# EUROPEAN PATENT SPECIFICATION

(11) **EP 0 587 680 B1**
(45) Date of publication and mention of the grant of the patent: **12.11.1997**
(21) Application number: 92911691.1
(22) Date of filing: 05.06.1992
(51) Int. Cl.: H04N 7/087, H04L 7/033, H03L 7/099

(54) **METHOD AND APPARATUS FOR DETECTING A SEQUENCE OF CLOCK REFERENCE PULSES**
VERFAHREN UND VORRICHTUNG ZUR DETEKTION EINER FOLGE VON TAKT REFERENZIMPULSEN
PROCEDE ET APPAREIL DESTINES A DETECTER UNE SEQUENCE D'IMPULSIONS D'HORLOGE DE REFERENCE

(30) Priority: 05.06.1991 GB 91121319
(43) Date of publication of application: 23.03.1994
(73) Proprietor: TEXAS INSTRUMENTS LIMITED, Sunbury-on-Thames, Middlesex TW16 7AH (GB)
(72) Inventor: KORATZINOS, Vassilis, GR-142 32 Perissos (GR)
(74) Representative: Legg, Cyrus James Grahame
(86) International application number: GB9201018
(87) International publication number: WO9222171

(56) References cited:
- EP-A- 0 043 407
- EP-A- 0 271 218
- GB-A- 2 129 658
- US-A- 4 984 249
- PATENT ABSTRACTS OF JAPAN vol. 11, no. 231 (E-527)26 August 1985 & JP-A-62 047 235

## Description

This invention relates to a method and apparatus for the detection of a clock run-in sequence of equally spaced similar input pulses to derive therefrom a control signal for a locally generated clock signal.

In teletext systems the data to be displayed as pages of information on the screen of a television receiver is conveyed in digital form in one or more of the lines of the composite video signal which are not used to convey video information for the conventional television picture. The digital data is coded in binary non-return to zero form and is preceded by a so-called clock run-in signal consisting of alternating ones and zeros and which appears as a succession of equally spaced pulses. A typical clock run-in sequence has eight such pulses. From the clock run-in sequence the phase of a locally generated clock is adjusted so that the decoding of the remainder of the digital data is correctly performed.

Difficulties in synchronising locally generated oscillations with the incoming data arise from distortion and corruption by spurious noise pulses of the clock run-in sequence and it is an object of the present invention to provide an improved method and apparatus for detecting the clock run-in sequence and for synchronising the locally generated oscillation to the incoming data.

US-A-4 984 249 discloses a digital circuit for sampling a digital waveform and feeding the samples into a shift register. The samples in the shift register are compared against a number of templates held in a ROM to provide estimates of the positions in the shift register of the midpoints of pulses of the waveform. Those estimates are used to select which of the parallel outputs of the shift register is supplied via a latch as the data recovered from the waveform. The latch is operated by a clock signal supplied by the circuit as the clock signal for the recovered data. That clock signal is obtained by dividing the clock signal used to control the sampling of the input waveform.

GB-A-2 129 658 discloses a circuit in which the phase of a clock signal is compared against that of the clock run-in pulses of a data signal. For each pulse of the clock signal, if the clock signal leads or lags then a signal is sent to increment or decrement a counter as appropriate. The counter controls which of a plurality of phases of the clock signal is used for the phase comparison against the clock run in pulses and subsequently to control the recovery of the data from the data signal.

EP-A-0 043 407 discloses a circuit in which the phase of a clock signal is compared to that of a reference pulse train. The clock signal and the reference pulse train are compared many times during a reference pulse to see how many times the clock signal is high and how many times the clock signal is low. The totals are subtracted to give a measure of the phase difference, which measure is used to adjust both the period and phase of the clock signal.

According to one aspect of the present invention there is provided apparatus responsive to a clock run-in sequence of equally spaced similar input pulses for a binary data packet to derive therefrom a control signal for a locally generated clock signal, the apparatus including
means for sampling the input pulses at much higher rate than the pulse repetition rate,
means for comparing the samples with a threshold voltage and for producing a single bit output for each sample which depends on whether or not the sample exceeds the threshold,
correlator means connected to receive the output bits in sequence from the comparing means and producing indications of the times of occurrence of the midpoints of the input pulses,
oscillator means,
divider means responsive to an oscillation from the oscillator means to provide the clock signal, and
phase comparison means for comparing the phase of the clock signal from the divider means with the indications from the correlator means and producing a phase adjustment signal which is applied to the divider means to adjust the phase of the clock signal.

The correlator means may include shift register means storing a plurality of bits from the comparing means together with logic means connected to certain stages of the shift register means for producing signals the value of which is a maximum when the bits derived from a single input pulse are symmetrically disposed in the shift register means. The detection of the maximum may be achieved by storing the values derived by the logic means as they are produced and comparing each stored value with the next subsequent value, the maximum being indicated the first time that the next subsequent value falls below the stored value. The logic means may also be arranged to produce indications of the times of occurrence of the midpoints of the spaces between pulses, the additional indications being used by the phase comparison means to adjust the phase of the clock signal. The correlator means may include means for producing an inhibit signal for blocking the operation of the logic means.

The threshold value used by the comparing means may start from an initial value substantially equal to zero and increase to a value near to that of the middle of the height of the input pulses.

The phase comparison means may include means for generating windows at predetermined time intervals determined by the oscillator means after the production of an indication, means for ascertaining the phases of the divider means concurrent with the occurrence of a plurality of subsequent indications during the windows, means for forming the average of the ascertained phases and means for resetting the divider means to a phase dependent on the average phase. The phase comparison means may include a state machine and an arithmetic logic unit, the state machine serving to cause the divider means to generate at least one narrow window and a plurality of further wider windows and providing output signals of a first kind when the subsequent indications occur within a window and an output signal of a second kind when one of the subsequent indications falls outside the window. The output signals of the first kind from the state machine may cause the divider means to produce signals representing the ascertained phases and the output signals of the second kind may be used to reset the divider means for generating the windows and the means for forming the average of the ascertained phases.

According to a second aspect of the present invention there is provided a method of detecting and deriving a control signal for a locally generated clock from a clock run-in sequence of equally spaced similar input pulses for a binary data packet, the method including
sampling the input pulses at a much higher rate than the pulse repetition rate,
comparing the samples with a threshold voltage and producing a single bit output for each sample which depends on whether or not the sample exceeds the threshold,
correlating the output bits in sequence and producing indications of the times of occurrence of the midpoints of the input pulses,
providing a locally generated clock signal by frequency dividing an oscillation,
comparing the phase of the locally generated clock with the indications produced by the correlation, and producing a phase adjustment signal, and
adjusting the phase of the locally generated clock signal using the phase adjustment signal.

An example of apparatus responsive to a clock run-in sequence to derive therefrom a control signal for a locally generated clock signal, and its method of operation will now be described with reference to the accompanying drawings, of which;-
- FIGURE 1: is a block diagram of the apparatus;
- FIGURE 2: is the circuit diagram of the correlator shown in Figure 1;
- FIGURE 3: is a diagram illustrating the operation of the maximum correlation detector; and
- FIGURE 4: is a diagram of the state machine and its associated components.

In the drawings the same reference numerals are used for the same component when it appears in different ones of the figures. For simplicity, the means to determine when to start looking for teletext data are not shown, it being assumed that the operation of the state machine 12 is controlled by a signal which starts the operation of the machine when the clock run-in of a packet of teletext data is expected. When the phase of the locally generated clock signal has been adjusted to be synchronised with the clock run-in sequence, the phase is held for the remainder of the data packet and the apparatus is disabled for that period.

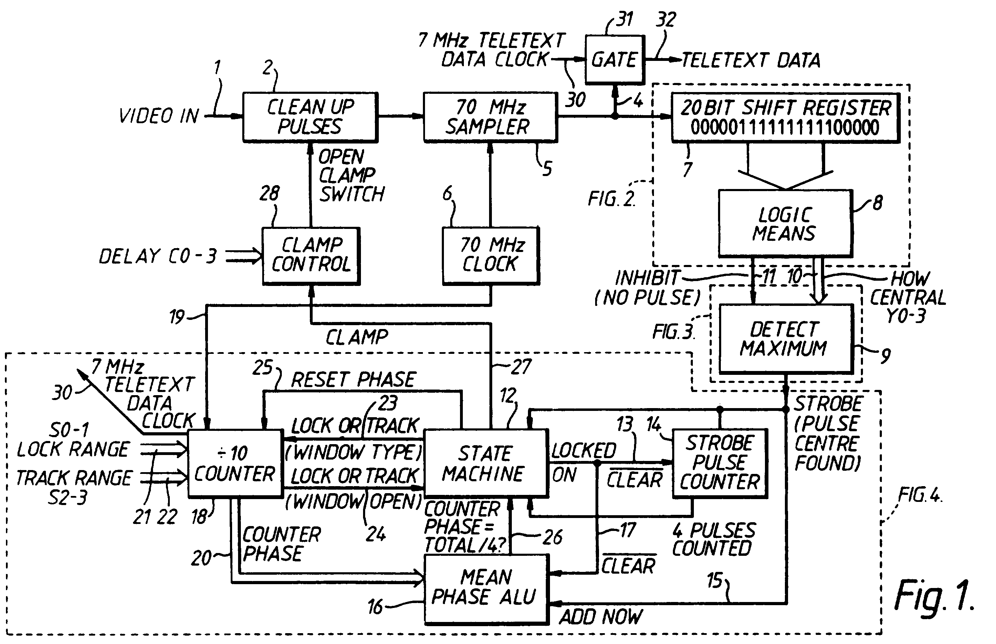

Referring now to Figure 1, composite television signals enter via a conductor 1 and are applied to a pulse cleaning-up circuit 2 which also receives clamp switch control signals via a conductor 3. The cleaned-up pulses from the circuit 2 are fed out to a 69.375 MHz sampler 5, the output of which takes the form of a 0 if the input signal level is below a threshold value and a 1 if the input signal is above that threshold value at the sampling instant and which is applied in serial form to a 20-bit shift register 7. The output of the sampler 5 is also applied to a conductor 4. The pulse repetition frequency of the teletext signal is 6.9375 MHz so that ten samples are taken from each pulse of the teletext signal by the sampler 5. For convenience in the following description the teletext p.r.f. is taken as 7 MHz and the sampling frequency as 70 MHz. The states of the stages of the shift register 7 are combined by logic means 8 which feeds two outputs to a maximum detector circuit 9. The first output is a 4-bit parallel code on conductors 10 which has a maximum value when a pulse or a space between pulses of the composite video input signal is most centrally disposed in the shift register 7. The second output which appears on a single conductor 11 is an inhibit signal which responds to combinations of the shift register stages to prevent the maximum detector circuit 9 from responding to values on the conductors 10 when a pulse or space is not centrally disposed in the shift register 7.

When the maximum detector circuit 9 detects a maximum value on the conductors 10, it produces a strobe output on conductor 15 which is applied to the state machine 12, a strobe pulse counter 14 and a mean phase ALU (arithmetic logic unit) 16. The state machine 12 produces an output on conductors 13 and 17 when it has received a strobe signal within a locking window produced by a divide-by-10 counter 18. The "locked on" signal on the conductors 13 and 17 free the strobe pulse counter 14 and the mean phase ALU 16 to start responding to the strobe signals. The divide-by-10 counter 18 receives 70 MHz clock pulses from clock 6 via a conductor 19 and executes repeated cycles of counting through the range 0 to 9 in response to those clock pulses. The phase of the counter 18 which is equal to the particular number in the range 0 to 9 which it has reached at the time, is applied in parallel form via conductors 20 to the main phase ALU 16. In addition to the lock window, the counter 18 produces track windows as well. The track windows are wider than the lock windows. The state machine 12 indicates via a conductor 23 whether the counter 18 is to produce a lock window or a track window and a signal indicating when the required window is open is fed from the counter 18 via the conductor 24 back to the state machine 12. For the adjustment of the phase of the counter 18, the state machine 12 feeds a signal via a conductor 25 to the counter 18. The mean phase ALU 16 applies a signal to the state machine 12 via a conductor 26 when the phase of the counter 18 is equal to the mean phase calculated by the ALU 16; that signal is used for bringing the counter 18 into synchronism with the clock run-in pulses received via the conductor 1. A clamping signal is fed from the state machine 12 via a conductor 27 to a clamp control circuit 28 for opening and closing the clamp in the pulse clean-up circuit 2. The counter 18 produces the 7 MHz teletext data clock on the line 30, which is connected to a gate 31 receiving the output of the sampler 5. The clock signal on the line 30 is of the phase to select the one of the ten bits from the sampler 5 that is most likely to be correct for each pulse from the clean-up circuit 2. The teletext data from the gate 31 appears on a conductor 32.

In the operation of the apparatus shown in Figure 1, the overall control of the apparatus is effected by the state machine 12 which receives as inputs signals representing particular conditions in different parts of the apparatus and produces control signals for starting the next operation to be executed. The state machine itself may be constructed of dedicated hardware consisting of logical elements and interconnected latches. Alternatively, the state machine may consist of a suitably programmed processor.

The clock run-in sequence which forms the start of a teletext data packet consists of the code 1010101010101010 in a non-return to zero code so that it appears as eight pulses separated by spaces of the same duration. The mark to space ratio may depart considerably from one to one, for example as a result of signal filtering and slicing, and the correlation technique used renders the circuit insensitive to such a distortion of the pulse sequence. Initially, the clamp switch of the pulse clean-up circuit is open with the video input AC coupled to a comparator circuit having a differential threshold value of zero. Just before the clock run-in pulses begin, the clamp switch is closed and as pulses are received so the threshold level of the comparator rises progressively over a few cycles to the mean value of the pulses. The clamp switch is opened again when the threshold voltage has reached the average of the clock run-in waveform so as to hold that level for the remainder of the data packet.

The output pulses from the circuit 2 are sampled at 70 MHz by the sampler 5, that is to say at ten times for each pulse and ten times for each space of the clock run-in waveform. The output signals from the sampler 5 pass in sequence into the shift register 7 and the logic means 8 connected to the shift register 7 in conjunction with the maximum detector circuit 9 looks for symmetrical patterns of 1's and 0's in the register 7. There are two ideal symmetrical patterns, one consisting of five 0's, then ten 1's and a further five 0's, and the other consisting of five 1's, then ten 0's and a further five 1's. Both patterns correspond respectively to pulses and spaces of the input composite signals, as represented by the sample values, being centrally disposed in the register 7, and when these patterns are detected or the nearest to them that appears, the maximum being affected by low signal values or noise pulses, the maximum detector circuit 9 produces a strobe output.

The state machine 12 on receiving a strobe output obtains from the divide-by-10 counter 18 a lock window around the expected time of occurrence of the next strobe pulse. If the first strobe pulse were caused by noise, then the second strobe pulse would be unlikely to occur within that window and the apparatus would reset and await another strobe pulse. On the other hand, if the first strobe pulse has been produced in response to the first pulse of the clock run-in sequence, then the second strobe pulse, that produced in response to the first space between pulses in the input signals, would occur within the lock window, and when this is detected by the state machine 12 a locked-on pulse is produced which releases the strobe pulse counter 14 to count and the mean phase ALU 16 to operate. The counter 14 will count the 1 for that strobe pulse and the mean phase ALU 16 will add into its accumulator the phase of the counter 10 at the time that the strobe signal is received via the conductors 20. Thereafter the state machine 12 will ask the counter 10 to provide some further track windows which are wider than the lock windows and will count the strobe signals falling within those windows and accumulate the phases of the counter 18 at the times of those strobe signals. In the example shown, the state machine produces a single lock window and three track windows, but other numbers of lock and track windows may be required by the state machine 12. When four strobe signals have occurred the counter 14 will indicate this fact to the state machine 12 and the mean phase ALU 16 will calculate automatically the mean of the phases of the counter 18 at the times of occurrence of the strobe signals. The next time that the counter 18 reaches the same phase as the mean phase calculated by the ALU 16, a signal is produced on the conductor 26 which causes the state machine 12 to send a reset signal via the conductor 25. The resetting of the counter 18 synchronises the phase of the teletext data clock on the line 30 with the maxima from the correlator.

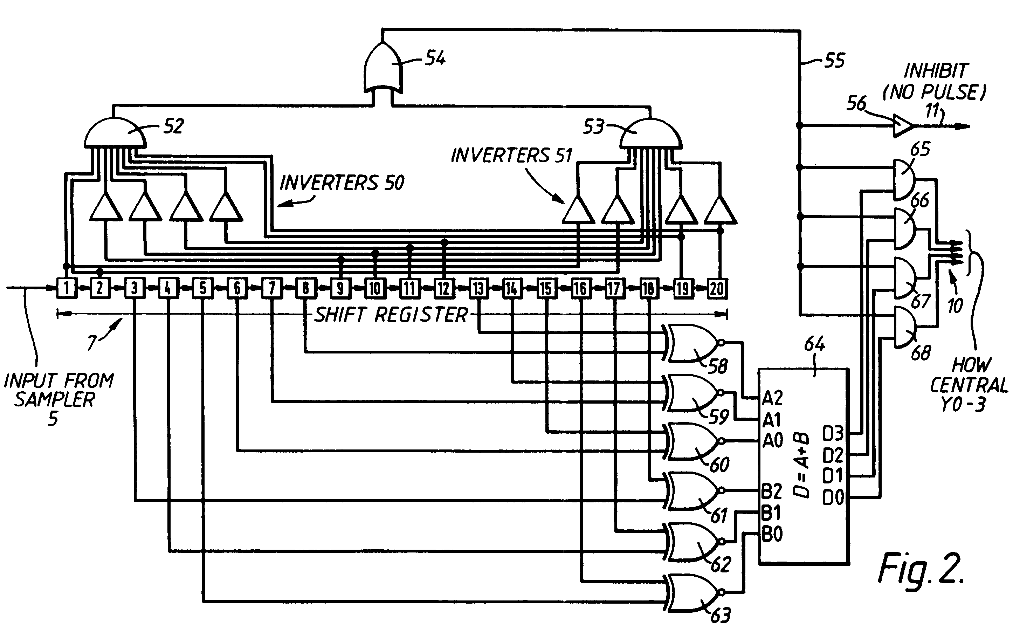

Figure 2 shows in detail the circuitry of the correlator formed by the shift register 7 and the logic means 8. In the production of the inhibit signal on the conductor 11, the first two and the last two stages of the shift register 7 are connected directly to inputs of an eight-input AND-gate 52 and through respective inverters 51 to inputs of a second eight-input AND-gate 53. The middle four stages of the shift register 7 are connected directly to inputs of the eight-input AND-gate 53 and through respective inverters 50 to inputs of the eight-input AND-gate 52. The outputs of the AND-gates 52 and 53 are connected through an OR-gate 54 to a conductor 55 feeding an inverter 56, the output of which is applied to the conductor 11. Symmetrically disposed pairs of stages of the shift register 7 are connected to the inputs of six exclusive NOR-gates 58, 59, 60, 61, 62 and 63, the outputs of which are applied to a binary adder 64, to inputs according to weighting factors applied to the outputs of the gates. The adder 64 has a four-bit parallel output. The four bits of the output from the adder 64 are applied as inputs to respective AND-gates 65, 66, 67 and 68, having their second inputs connected to the conductor 55. The outputs of the gates 65 to 68 are applied to the four conductors 10.

In the operation of the circuit shown in Figure 2, the inverters 50 and 51 and the gates 52, 53 and 54 serve to produce on the conductor 55 a 1 signal only if the middle four stages of the shift register 7 are in the same state and in a different state from that of the outer four stages of the register. Clearly, that situation should be reached whenever a pulse or a space between pulses of a clock run-in sequence has been received and is stored symmetrically in the register 7. The absence of a 1 on the conductor 55 is used to produce an inhibit pulse on the conductor 11. The inhibit pulses serve to reduce interference by spurious noise pulses which might otherwise appear as pulses of the clock run-in sequence.

The exclusive NOR-gates 58 to 63 with the adder 64 serve to form a weighted sum of the symmetrically disposed pairs of stages having matching states of the shift register 7, the sum having a maximum value 4-bit output when a pulse or space is centrally disposed in the shift register 7. The weighting of the outputs of the gates 58 to 63 is selected so that there is a single position providing a maximum sum. The gates 65 to 68 provide the signal on the conductor 55 with the power to block the production of a value on the conductors 10 if signal on the conductor 55 is not a 1.

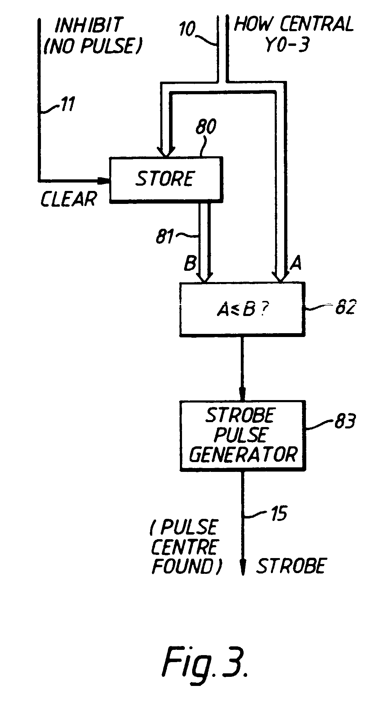

Figure 3 shows in detail the operation of the maximum detector 9. The conductors 10 are applied to a 4-bit store 80 and a 4-bit comparator 82. The store 80 is connected to a second input of the comparator 82 through four conductors 81. The inhibit pulse on conductor 11 is applied to the store 80 to clear it and prevent operation of the circuit. If the input value on the conductors 10 is smaller or equal to the value stored in the store 80, then the comparator 82 applies an output to a strobe pulse generator 83 which generates the strobe signal on the conductor 15. A strobe signal is produced on only the first fall in value after an increase in value.

The operation of the maximum detector shown in Figure 3 makes use of the fact that when a maximum value has been reached the next following value is either equal to or smaller than the maximum value. The store 80 is constructed so as to store the last value that occurred before the current one on the conductors 10 so that the comparator 82 provides the function of detecting the maximum value by comparing the earlier value from the store 80 with the later one on the conductor 10, and producing an output if the latter value is equal to or less than the stored value.

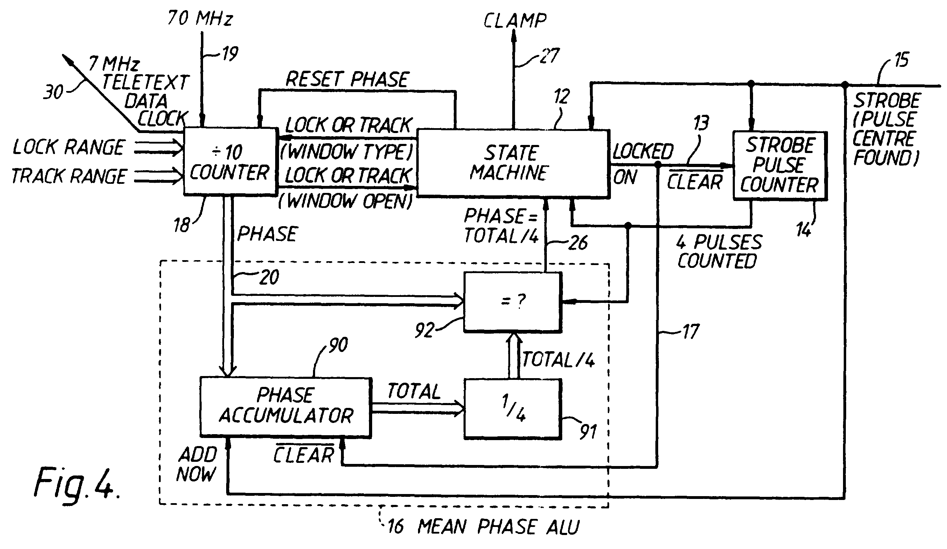

Figure 4 is diagram showing the state machine 12 and the components most closely associated with it. In particular in Figure 4 the mean phase ALU 16 is shown as comprising an accumulator 90, a divide-by-4 circuit 91 and a comparator 92. As mentioned above with reference to Figure 1, the ALU 16 accumulates the phase values from the counter 18 which are present at the time of the strobe signals on the conductor 15. In Figure 4, that accumulation is performed by the accumulator 90 which receives the phase values via the conductors 20 and adds each of them to the accumulated total when the strobe signal appears on the conductor 15. The divide-by-4 circuit 91 receives the total from the accumulator 90 and divides it by four by the simple expedient of removing the two bits of least significance. The quotient of the division is applied to the comparator 92 where it is compared with the phase from the counter 18 appearing on the conductors 20. The operation of the comparator 92 is inhibited until the counter 14 produces an output indicating that it has received four strobe signals via the conductor 15 so that the total in the accumulator 90 will be of four phase values. When the phase values from the counter 18 is equal to the quotient produced by the divider 91 a signal is applied via the conductor 26 to the state machine 12 for the purpose of causing the appropriate adjustment of the phase of the counter 18. When that phase adjustment has been completed, the state machine terminates the operation of the apparatus, thereby holding the phase of the counter 18 and the output of the teletext data clock on the conductor 30.

As described above, the division by four by the divider 91 does not take into account the possibility that the true value of the quotient may involve one-half or three-quarters over the value applied to the comparator 92. Rounding up of the value would give a more accurate setting of the phase of the counter 18 and such rounding up could conveniently be achieved by the selective introduction of a single clock pulse period delay (at 70 MHz) into the generation of the signal applied to the conductor 26 indicating the equivalence of the current phase value on the conductors 20 and the quotient from the divider 91. Such delay would be introduced if the larger of the two bits discarded to effect the division by four were a 1. The operation of the delay would be equivalent to adding 1 to the phase value produced by the counter 18 because that value would be increased by 1 during the delay.

## Claims

1. Apparatus responsive to a clock run-in sequence of equally spaced similar input pulses for a binary data packet to derive therefrom a control signal for a locally generated clock signal (30), the apparatus including
means (5) for sampling the input pulses at much higher rate than the pulse repetition rate,
means (5) for comparing the samples with a threshold voltage and for producing a single bit output for each sample which depends on whether or not the sample exceeds the threshold,
correlator means (7,8,9) connected to receive the output bits in sequence from the comparing means and producing indications of the times of occurrence of the midpoints of the input pulses,
oscillator means (6),
divider means (18) responsive to an oscillation from the oscillator means to provide the clock signal, and
phase comparison means (12,14,16) for comparing the phase (20) of the clock signal (30) from the divider means with the indications from the correlator means and producing a phase adjustment signal (25) which is applied to the divider means (18) to adjust the phase of the clock signal.

2. Apparatus according to claim 1, wherein the correlator means includes
shift register means (7) for storing a plurality of bits from the comparing means (5), the plurality being derived from a longer time section of the input pulses than a single input pulse,
logic means (18) connected to certain stages (3,4,5,6,7,8,13,14,15,16,17,18) of the shift register means for producing signals the value of which is a maximum when bits derived from a single input pulse are centrally disposed in the shift register means, and means (9) for producing an indication (15) when the signals produced by the logic means reach a maximum value.

3. Apparatus according to claim 2, wherein the means (9) for producing an indication when the signals produced by the logic means (8) reach a maximum value includes means (80) for storing each value in turn and means (82) for comparing the stored value with the next subsequent value and providing the indication the first time that the stored value exceeds the next subsequent value.

4. Apparatus according to claim 1, 2 or 3,
wherein the correlator means (7,8,9) is also responsive to the output bits in sequence to produce additional indications (15) of the times of occurrence of the midpoints of the spaces between pulses, and
the phase comparison (12,14,16) means also compares the phase (20) of the clock signal (30) with the additional indications (15) from the correlator means.

5. Apparatus according to claim 2, 3 or 4 wherein the correlator means includes second logic means (50,51,52,53,54) responsive to stages (1,2,9,10,11,12,19,20) of the shift register means other than the certain stages to produce an inhibit signal (11) for blocking the operation of the first-mentioned logic means (8).

6. Apparatus according to any one of the preceding claims, wherein the phase comparison means (12,14,16) includes
means (18) for generating windows at predetermined time intervals determined by the oscillator means after the production of an indication by the correlator means (7,8,9),
means (16) for ascertaining the phases of the divider means concurrent with a plurality of subsequent indications produced by the correlator means during the windows,
means (16) for forming the average of the ascertained phases of the divider means, and
means (12) for resetting the divider means to a phase dependent on the average phase.

7. Apparatus according to claim 6,
wherein the number of ascertained phases is a power of two and the means for forming the average of the ascertained phases includes means (90,91) for accumulating the ascertained phases in binary coded form and shifting the accumulated total the appropriate number of binary places to effect division by the number of ascertained phases.

8. Apparatus according to claim 7,
wherein the means for forming the average of the ascertained phases includes means responsive to the magnitude of the remainder after shifting to effect division by the number of ascertained phases for delaying the resetting of the divider means by a single clock pulse interval so as selectively to round up or round down the average phase on which the resetting is dependent.

9. Apparatus according to claim 5, 7 or 8,
wherein the phase comparison means includes a state machine (12),
the state machine receiving the indications (15) from the correlator means and operating to produce after one of the indications at least one narrow window and a plurality of further wider windows and providing output signals of a first kind when subsequent indications occur within the windows and an output signal of a second kind when one of the subsequent indications occurs outside a window,
the output signals of the first kind from the state machine being applied to the divider means (18) to cause it to produce signals (20) representing the ascertained phases, and the output signals of the second kind from the state machine being applied to reset the means for generating the windows and the means for forming the average of the ascertained phases.

10. Apparatus according to any one of the preceding claims
wherein the comparing means (5) is such that the threshold voltage starts from an initial value substantially equal to zero and increases to a value near to that of the middle of the height of the input pulses.

11. Apparatus according to any one of the preceding claims for detecting and responding to the clock run-in sequence of teletext signals included with a broadcast composite television signal.

12. A method of detecting and deriving a control signal for a locally generated clock (30) from a clock run-in sequence of equally spaced similar input pulses for a binary data packet, the method including
sampling the input pulses (1) at a much higher rate than the pulse repetition rate,
comparing the samples with a threshold voltage and producing a single bit output (4) for each sample which depends on whether or not the sample exceeds the threshold,
correlating the output bits in sequence and producing indications (15) of the times of occurrence of the midpoints of the input pulses,
providing a locally generated clock (30) signal by frequency dividing an oscillation,
comparing the phase of the locally generated clock with the indications produced by the correlation, and producing a phase adjustment signal, and
adjusting the phase of the locally generated clock signal using the phase adjustment signal.

13. A method according to claim 12,
wherein the correlation of the output bits in sequence produces additional indications (15) of the times of occurrence of the midpoints of the spaces between the input pulses, the production of the phase adjustment signal also taking into account the comparison of the phase of the locally generated clock with the additional indications.

14. A method according to claim 12 or 13, in which the comparing of the phase of the locally generated clock with the indications produced by the correlation is effected by generating windows at predetermined time intervals determined by the oscillation after the production of an indication by the correlation providing the locally generated clock signal, ascertaining the phases of the frequency division used to produce the locally generated clock signal which are concurrent with a plurality of subsequent indications produced by the correlation, forming the average of the ascertained phases and resetting the frequency division to a phase dependent on the average phase.

15. A method according to any one of claims 12, 13 or 14 in which the threshold voltage starts from an initial value substantially equal to zero and increases to a value near to that of the middle of the height of the input pulses.

## Patentansprüche

1. Vorrichtung, die auf eine Einschwing-Taktsequenz gleichmäßig beabstandeter Eingangsimpulse für ein binäres Datenpaket anspricht, um daraus ein Steuersignal für ein lokal erzeugtes Taktsignal (30) abzuleiten, wobei die Vorrichtung enthält:
eine Einrichtung (5) zum Abtasten der Eingangsimpulse mit einer erheblich höheren Rate als die Taktwiederholrate,
eine Einrichtung (5) zum Vergleichen der Abtastwerte mit einer Schwellenspannung und zum Erzeugen eines einzelnen Ausgangsbits für jeden Abtastwert, der davon abhängt, ob der Abtastwert die Schwelle überschreitet oder nicht überschreitet,
eine Korrelationseinrichtung (7, 8, 9), die so angeschlossen ist, daß sie die Ausgangsbits von der Vergleichseinrichtung sequentiell empfängt und Angaben bezüglich der Zeiten erzeugt, zu denen die Mittelpunkte der Eingangs impulse auftreten,
eine Oszillatoreinrichtung (6),
eine Divisionseinrichtung (18), die auf eine Schwingung von der Oszillatoreinrichtung anspricht, um das Taktsignal zu erzeugen, und
eine Phasenvergleichseinrichtung (12, 14, 16) zum Vergleichen der Phase (20) des Taktsignals (30) von der Divisionseinrichtung mit den Angaben von der Korrelationseinrichtung und zum Erzeugen eines Phaseneinstellsignals (25), das an die Divisionseinrichtung (18) angelegt wird, um die Phase des Taktsignals einzustellen.

2. Vorrichtung nach Anspruch 1, bei der die Korrelationseinrichtung enthält:
eine Schieberegistereinrichtung (7) zum Speichern mehrerer Bits von der Vergleichseinrichtung (5), wobei die mehreren Bits aus einem Zeitbereich der Eingangsimpulse, der länger als ein einzelner Eingangsimpuls ist, abgeleitet werden,
eine Logikeinrichtung (18), die an bestimmte Stufen (3, 4, 5, 6, 7, 8, 13, 14, 15, 16, 17, 18) der Schieberegistereinrichtung angeschlossen ist, um Signale zu erzeugen, deren Wert maximal ist, wenn die aus einem einzelnen Eingangsimpuls abgeleiteten Bits in der Schieberegistereinrichtung zentral angeordnet sind, und eine Einrichtung (9) zum Erzeugen einer Angabe (15), wenn die von der Logikeinrichtung erzeugten Signale einen Maximalwert erreichen.

3. Vorrichtung nach Anspruch 2, bei der die Einrichtung (9), die eine Angabe erzeugt, wenn die von der Logikeinrichtung (8) erzeugten Signale einen Maximalwert erreichen, eine Einrichtung (80) zum Speichern jedes aktuellen Werts sowie eine Einrichtung (82) zum Vergleichen des gespeicherten Werts mit dem direkt nachfolgenden Wert und zum Erzeugen der Angabe, sobald der gespeicherte Wert den direkt nachfolgenden Wert übersteigt, enthält.

4. Vorrichtung nach Anspruch 1, 2 oder 3,
bei der die Korrelationseinrichtung (7, 8, 9) außerdem auf die sequentiellen Ausgangsbits anspricht, um zusätzliche Angaben (15) bezüglich der Zeiten zu erzeugen, zu denen die Mittelpunkte der Zwischenräume zwischen Impulsen auftreten, und
die Phasenvergleichseinrichtung (12, 14, 16) außerdem die Phase (20) des Taktsignals (30) mit den zusätzlichen Angaben (15) von der Korrelationseinrichtung vergleicht.

5. Vorrichtung nach Anspruch 2, 3 oder 4, bei der die Korrelationseinrichtung eine zweite Logikeinrichtung (50, 51, 52, 53, 54) enthält, die auf Stufen (1, 2, 9, 10, 11, 12, 19, 20) der Schieberegistereinrichtung, die von den bestimmten Stufen verschieden sind, anspricht, um ein Sperrsignal (11) zu erzeugen, mit dem die Operation der erstgenannten Logikeinrichtung (8) gesperrt wird.

6. Vorrichtung nach irgendeinem der vorangehenden Ansprüche, bei der die Phasenvergleichseinrichtung (12, 14, 16) enthält:
eine Einrichtung (18) zum Erzeugen von Fenstern in vorgegebenen, durch die Oszillatoreinrichtung bestimmten Zeitintervallen, nachdem durch die Korrelationseinrichtung (7, 8, 9) eine Angabe erzeugt worden ist,
eine Einrichtung (16) zum Bestimmen der Phasen der Divisionseinrichtung, die zu mehreren nachfolgenden Angaben, die von der Korrelationseinrichtung während der Fenster erzeugt werden, konkurrent sind,
eine Einrichtung (16) zum Bilden des Durchschnitts der bestimmten Phasen der Divisioneinrichtung und
eine Einrichtung (12) zum Zurücksetzen der Divisionseinrichtung auf eine Phase, die von der Durchschnittsphase abhängt.

7. Vorrichtung nach Anspruch 6,
bei der die Anzahl der bestimmten Phasen eine Zweierpotenz ist und die Einrichtung zum Bilden des Durchschnitts der bestimmten Phasen eine Einrichtung (90, 91) enthält, die die bestimmten Phasen in binärcodierter Form sammelt und die gesammelte Gesamtheit um die geeignete Anzahl von binären Plätzen verschiebt, um eine Division durch die Anzahl der bestimmten Phasen vorzunehmen.

8. Vorrichtung nach Anspruch 7,
bei der die Einrichtung zum Bilden des Durchschnitts der bestimmten Phasen eine Einrichtung enthält, die auf die Größe des Rests nach der verschiebung, mit der die Division durch die Anzahl der bestimmten Phasen bewerkstelligt wird, anspricht, um das Zurücksetzen der Divisionseinrichtung um ein einzelnes Taktimpulsintervall zu verzögern, um so die Durchschnittsphase, von der das Zurücksetzen abhängt, wahlweise auf- oder abzurunden.

9. Vorrichtung nach Anspruch 5, 7 oder 8,
bei der die Phasenvergleichseinrichtung eine Zustandsmaschine (12) enthält,
die Zustandsmaschine die Angaben (15) von der Korrelationseinrichtung empfängt und in der Weise arbeitet, daß sie nach einer der Angaben wenigstens ein schmales Fenster sowie mehrere breitere Fenster erzeugt und Ausgangssignale einer ersten Art erzeugt, wenn nachfolgende Angaben in den Fenstern auftreten, und ein Ausgangssignal einer zweiten Art erzeugt, wenn eine der nachfolgenden Angaben außerhalb eines Fensters auftritt,
die Ausgangssignale der ersten Art von der Zustandsmaschine an die Divisionseinrichtung (18) angelegt werden, damit diese Signale (20) erzeugt, die die bestimmten Phasen darstellen, und die Ausgangssignale der zweiten Art von der Zustandsmaschine angelegt werden, um die Einrichtung zum Erzeugen der Fenster und die Einrichtung zum Bilden des Durchschnitts der bestimmten Phasen zurückzusetzen.

10. Vorrichtung nach irgendeinem der vorangehenden Ansprüche,
bei der die Vergleichseinrichtung (5) so beschaffen ist, daß die Schwellenspannung bei einem Anfangswert, der im wesentlichen gleich null ist, beginnt und auf einen Wert in der Nähe der halben Höhe der Eingangsimpulse ansteigt.

11. Vorrichtung nach irgendeinem der vorangehenden Ansprüche, zum Erfassen der eingehenden Taktsequenz von Teletextsignalen und zum Ansprechen darauf, wobei die Teletextsignale in einem zusammengesetzten Fernsehübertragungssignal enthalten sind.

12. Verfahren zum Erfassen und Ableiten eines Steuersignals für einen lokal erzeugten Takt (30) aus einer eingehenden Taktsequenz gleichmäßig beabstandeter, ähnlicher Eingangsimpulse für ein binäres Datenpaket, wobei das Verfahren enthält:
Abtasten der Eingangsimpulse (1) mit einer viel höheren Rate als die Impulswiederholrate,
Vergleichen der Abtastwerte mit einer Schwellenspannung und Erzeugen eines Einzelbitausgangs (4) für jeden Abtastwert, der davon abhängt, ob der Abtastwert die Schwelle überschreitet oder nicht,
Korrelieren der sequentiellen Ausgangsbits und Erzeugen von Angaben (15) bezüglich der Zeiten, zu denen die Mittelpunkte der Eingangsimpulse auftreten,
Erzeugen eines lokal erzeugten Taktsignals (30) durch Frequenzteilung einer Schwingung,
Vergleichen der Phase des lokal erzeugten Takts mit den durch die Korrelation erzeugten Angaben und Erzeugen eines Phaseneinstellsignals und
Einstellen der Phase des lokal erzeugten Taktsignals unter Verwendung des Phaseneinstellsignals.

13. Verfahren nach Anspruch 12,
bei dem die Korrelation der sequentiellen Ausgangsbits zusätzliche Angaben (15) bezüglich der Zeiten erzeugt, zu denen die Mittelpunkte der Zwischenräume zwischen den Eingangs impulsen auftreten, wobei bei der Erzeugung des Phaseneinstellsignals auch der Vergleich der Phase des lokal erzeugten Takts mit den zusätzlichen Angaben berücksichtigt wird.

14. Verfahren nach Anspruch 12 oder 13, bei dem der Vergleich der Phase des lokal erzeugten Takts mit den von der Korrelation erzeugten Angaben ausgeführt wird durch Erzeugen von Fenstern in vorgegebenen Zeitintervallen, die durch die Schwingung bestimmt sind, nachdem eine Angabe durch die Korrelation, die das lokal erzeugte Taktsignal ergibt, erzeugt worden ist, durch Bestimmen der Phasen der Frequenzteilung, die für die Erzeugung des lokal erzeugten Taktsignals verwendet wird, die mit mehreren nachfolgenden Angaben, die durch die Korrelation erzeugt werden, konkurrent sind, durch Bilden des Durchschnitts der bestimmten Phasen und durch Zurücksetzen der Frequenzteilung auf eine von der Durchschnittsphase abhängende Phase.

15. Verfahren nach irgendeinem der Ansprüche 12, 13 oder 14, bei dem die Schwellenspannung bei einem Anfangswert, der im wesentlichen null ist, beginnt und auf einen Wert in der Nähe der halben Höhe der Eingangsimpulse ansteigt.

## Revendications

1. Appareil sensible à une séquence d'horloge incidente d'impulsions d'entrée similaires régulièrement espacées pour un paquet de données binaires pour en déduire un signal de commande pour un signal d'horloge généré localement (30), l'appareil comprenant :
- des moyens (5) pour échantillonner les impulsions d'entrée à une fréquence très supérieure à la fréquence de répétition des impulsions,
- des moyens (5) pour comparer les échantillons avec une tension de seuil et pour produire une sortie à un bit pour chaque échantillon qui dépend du fait que l'échantillon excède ou n'excède pas le seuil,
- des moyens de corrélation (7, 8, 9) connectés pour recevoir les bits de sortie en séquence provenant des moyens de comparaison et produire des indications des instants d'apparition du point central des impulsions d'entrée,
- des moyens d'oscillation (6),
- des moyens diviseurs (18) sensibles à une oscillation provenant des moyens d'oscillation pour fournir le signal d'horloge, et
- des moyens de comparaison de phase (12, 14, 16) pour comparer la phase (20) du signal d'horloge (30) provenant des moyens de division avec des indications provenant des moyens de corrélation et produire un signal d'ajustement de phase (25) qui est appliqué aux moyens diviseurs (18) pour ajuster la phase du signal d'horloge.

2. Appareil selon la revendication 1, dans lequel les moyens de corrélation comportent :
- des moyens formant registre à décalage (7) pour le stockage d'une pluralité de bits provenant des moyens de comparaison (5), la pluralité étant déduite à partir d'une section de durée des impulsions d'entrée supérieure à une impulsion d'entrée unique,
- des moyens logiques (18) connectés à certains étages (3, 4, 5, 6, 7, 8, 13, 14, 15, 16, 17, 18) des moyens formant registre à décalage pour produire des signaux dont la valeur est maximale lorsque des bits déduits d'une impulsion d'entrée unique sont disposés de façon centrale dans les moyens formant registre à décalage, et des moyens (9) pour produire une indication (15) lorsque les signaux produits par les moyens logiques atteignent une valeur maximale.

3. Appareil selon la revendication 2, dans lequel les moyens (9) pour produire une indication lorsque les signaux produits par les moyens logiques (8) atteignent une valeur maximale comportent des moyens (80) pour le stockage de chaque valeur, à leur tour, et des moyens (82) pour comparer la valeur stockée avec la valeur suivante consécutive et fournir l'indication la première fois que la valeur stockée dépasse la valeur consécutive suivante.

4. Appareil selon l'une quelconque des revendications 1 à 3, dans lequel les moyens de corrélation (7, 8, 9) est également sensible aux bits de sortie en séquence pour produire des indications additionnelles (15) des instants d'apparition des points centraux des espaces entre l'impulsion, et les moyens de comparaison de phase (12, 14, 16) comparent également la phase (20) du signal d'horloge (30) avec les indications additionnelles (15) provenant des moyens de corrélation.

5. Appareil selon l'une quelconque des revendications 2 à 4, dans lequel les moyens de corrélation comportent des deuxième moyens logiques (51, 52, 53, 54) sensibles aux étages (1, 2, 9, 10, 11, 12, 19, 20) des moyens formant registre à décalage autres que lesdits certains étages pour produire un signal d'inhibition (11) pour bloquer le fonctionnement des moyens logiques (8) mentionnés en premier lieu.

6. Appareil selon l'une quelconque des revendications précédentes, dans lequel les moyens de comparaison de phase (12, 14, 16) comportent :
- des moyens (18) pour générer des fenêtres à des intervalles de temps prédéterminés, déterminés par les moyens d'oscillation après la production d'une indication par les moyens de corrélation (7, 8, 9),
- des moyens (16) pour estimer les phases des moyens diviseurs simultanément à une pluralité d'indications consécutives produites par les moyens de corrélation au cours des fenêtres,
- des moyens (16) pour former la moyenne des phases estimées des moyens diviseurs, et
- des moyens (12) pour positionner les moyens diviseurs sur une phase dépendante de la phase moyenne.

7. Appareil selon la revendication 6, dans lequel le nombre de phases estimées est une puissance de 2 et les moyens pour former la moyenne des phases estimées comportent des moyens (90, 91) pour accumuler les phases estimées sous une forme codée en binaire et décaler le total accumulé le nombre de places binaires approprié pour effectuer une division par le nombre de phases estimées.

8. Appareil selon la revendication 7, dans lequel les moyens pour former la moyenne des phases estimées comportent des moyens sensibles à l'amplitude des phases restantes après décalage pour effectuer une division par le nombre de phases estimées pour retarder le positionnement des moyens diviseurs d'un intervalle entre impulsions d'horloge unique de manière à arrondir par majoration ou minoration la phase moyenne de laquelle le positionnement est dépendant.

9. Appareil selon l'une quelconque des revendications 5, 7 et 8, dans lequel les moyens de comparaison de phases comportent une machine à état (12), la machine à état recevant les indications (15) provenant des moyens de corrélation et fonctionnant pour produire après l'une des indications au moins une fenêtre étroite et une pluralité d'autres fenêtres plus larges et fournir des signaux de sortie d'un premier type lorsque les indications consécutives apparaissent à l'intérieur des fenêtres et un signal de sortie d'un deuxième type lorsque l'une des indications consécutives apparaît à l'extérieur d'une fenêtre, les signaux de sortie du premier type provenant de la machine à état étant appliqués aux moyens diviseurs (18) pour provoquer par ceux-ci la production de signaux (20) représentant les phases estimées, et les signaux de sortie du deuxième type provenant de la machine à état étant appliqués pour positionner les moyens pour engendrer les fenêtres et les moyens pour former la moyenne des phases estimées.

10. Appareil selon l'une quelconque des revendications précédentes, dans lequel les moyens de comparaison (5) sont adaptés pour que la tension de seuil débute à partir d'une valeur initiale sensiblement égale à zéro, et augmente jusqu'à une valeur proche de celle du milieu de l'amplitude des impulsions d'entrée.

11. Appareil selon l'une quelconque des revendications précédentes pour détecter et répondre à des séquences d'horloge incidentes de signaux de télétexte inclus dans un signal de télévision composite radiodiffusé.

12. Procédé de détection et de déduction d'un signal de commande pour une horloge générée localement (30) à partir d'une séquence d'horloge incidente d'impulsions d'entrée similaires régulièrement espacées pour un paquet de données binaires, le procédé comprenant :
- un échantillonnage des impulsions d'entrée (1) à une fréquence très supérieure à la fréquence de répétition des impulsions,
- la comparaison des échantillons avec une tension de seuil et ia production d'une sortie à un seul bit (4) pour chaque échantillon qui dépend du fait que l'échantillon excède ou n'excède pas le seuil,
- la corrélation des bits de sortie en séquence et la production d'indications (15) des instants d'apparition des points milieu des impulsions d'entrée,
- la fourniture d'un signal (30) d'horloge généré localement par division d'une oscillation,
- la comparaison de la phase de l'horloge générée localement avec les indications produites par la corrélation, et la production d'un signal d'ajustement de phase, et
- l'ajustement de la phase du signal d'horloge généré localement en utilisant le signal d'ajustement de phase.

13. Procédé selon la revendication 12, dans lequel la corrélation des bits de sortie en fréquence produit des indications additionnelles (15) des instants d'apparition des points milieu des espaces entre les impulsions d'entrée, la production du signal d'ajustement de phases prenant également en compte la comparaison de la phase de l'horloge générée localement avec les indications additionnelles.

14. Procédé selon l'une des revendications 12 et 13, dans lequel la comparaison de la phase de l'horloge générée localement avec les indications produites par la corrélation est effectuée en générant des fenêtres à des intervalles de temps prédéterminés, déterminés par l'oscillation après la production d'une indication par la corrélation fournissant le signal d'horloge généré localement, en estimant les phases de la division de fréquence utilisée pour produire le signal d'horloge généré localement qui coïncident avec une pluralité d'indications consécutives produites par la corrélation, en formant la moyenne des phases estimées et en repositionnant la division de fréquences à une phase dépendante de la phase moyenne.

15. Procédé selon l'une quelconque des revendications 12, 13 et 14, dans lequel la tension de seuil débute à partir d'une valeur initiale sensiblement égale à zéro et augmente jusqu'à une valeur proche de celle du milieu de l'amplitude des impulsions d'entrée.
